(19) Europäisches Patentamt / European Patent Office / Office européen des brevets

(11) **EP 4 092 689 A1**

(12) **DEMANDE DE BREVET EUROPEEN**

(43) Date de publication:
**23.11.2022 Bulletin 2022/47**

(21) Numéro de dépôt: **22173617.6**

(22) Date de dépôt: **16.05.2022**

(51) Classification Internationale des Brevets (IPC):
**H01B 7/30** (2006.01)    **H01B 7/28** (2006.01)
**H01B 7/29** (2006.01)

(52) Classification Coopérative des Brevets (CPC):
**H01B 7/30; H01B 3/445; H01B 7/2813; H01B 7/29**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **21.05.2021 FR 2105353**

(71) Demandeur: **Nexans**
**92400 Courbevoie (FR)**

(72) Inventeurs:
• **HÄHNER, Thomas**
 **91370 VERRIERES LE BUISSON (FR)**
• **RYBSKI, Patrick**
 **91330 YERRES (FR)**

(74) Mandataire: **Ipsilon**
**Le Centralis**
**63, avenue du Général Leclerc**
**92340 Bourg-la-Reine (FR)**

(54) **CÂBLE ÉLECTRIQUE LIMITANT LES DÉCHARGES PARTIELLES**

(57) L'invention concerne un câble aéronautique limitant l'apparition de décharges partielles, comportant un élément électriquement conducteur allongé entouré d'une couche semi-conductrice et un système d'isolation autour de la couche semi-conductrice, ce système d'isolation comportant une couche électriquement isolante entourant ladite couche semi-conductrice, chaque couche du système d'isolation présentant une épaisseur radiale (ei... ), et en ce qu'une épaisseur équivalente (teq) d'isolation de ce système d'isolation est supérieure ou égal au résultat d'une équation polynomiale d'ordre 3 fonction d'une pression minimale et d'une température maximale auxquelles le câble est destiné à être utilisé.

[Fig. 2]

EP 4 092 689 A1

**Description**

La présente invention concerne un élément électriquement conducteur isolé, ou câble, limitant l'apparition de décharges partielles ainsi qu'un câble électriquement conducteur comprenant un tel élément.

Les câbles électriques comprennent généralement au moins un élément électriquement conducteur entouré d'au moins une couche d'un matériau isolant et éventuellement une ou plusieurs couche(s) d'un matériau semiconducteur.

Lors du fonctionnement du câble, des décharges partielles peuvent être générées. Ces décharges partielles peuvent apparaitre à la surface de l'isolation et/ou dans l'isolation lorsque des bulles ou cavités d'air sont présentes dans la ou les couches entourant l'élément électriquement conducteur ou entre une couche et l'élément (conducteur ou couche) qu'elle entoure.

Dans le domaine de l'aéronautique, les câbles sont soumis à des tensions élevées ce qui, associé aux conditions d'humidité, de température élevée et de basse pression, peut favoriser l'apparition de décharges partielles. Les décharges partielles, qui sont de minuscules arcs électriques dans le matériau isolant, provoquent, avec le temps, une dégradation du matériau électriquement isolant, notamment par érosion lente, pouvant mener à sa rupture diélectrique. Une solution pour éviter que les décharges partielles apparaissent est souvent d'augmenter l'épaisseur de la couche isolante.

Le problème des décharges partielles dans les câbles électriques, est d'autant plus important avec le développement de systèmes de propulsion hydrides ou électriques, notamment dans le domaine de l'aéronautique. En effet, dans de tels systèmes, les câbles vont devoir transporter des tensions et intensités de plus en plus élevées pour atteindre des puissances pouvant aller jusqu'à plusieurs dizaines de mégavoltampères (MVA).

Par ailleurs, à haute tension, des décharges partielles à la surface du câble sont observées, il s'agit de l'effet corona qui s'observe plus particulièrement à basse pression et haute température. Dans un avion en vol, la pression extérieure à laquelle est exposé un câble, qui n'est pas dans la zone à pressurisation régulée de l'avion, peut chuter par exemple jusqu'à 145 hPa (145 mbar), voire même jusqu'à 90 hPa (90 mbar).

A de telles valeurs élevées de tensions, il est connu dans les solutions dédiées à la distribution d'énergie terrestre, des câbles tricouches dont la couche isolante est placée entre deux couches semiconductrices. Néanmoins cette solution nécessite que la couche semiconductrice extérieure soit enlevée pour le montage de la connectique et que le système de connexion intègre un système avec contrôle du champ électrique, ce qui rend difficile l'utilisation de cette solution dans le domaine aéronautique. Les câbles tricouches présentent aussi une épaisseur importante pour éviter l'apparition de décharges partielles.

Or dans le domaine de l'aéronautique, les contraintes peuvent être variables. Tous les avions n'ayant pas vertu à voler à très haute altitude (13, 7 km soit 45 kft), il existe un besoin pour des câbles adaptés à des usages aéronautiques ayant des contraintes de fonctionnement intermédiaires, notamment des altitudes de vol inférieures à 10,6 km (35kft), et exposés à des tensions inférieures à 1000V. De plus, il existe un besoin pour faciliter l'usage de tels câbles aéronautiques, qui ne nécessitent pas de préparation spéciale de leur terminaison pour permettre leur connexion.

Il existe donc un besoin pour un câble prêt à l'emploi et apte à être connecté sans modification de sa terminaison, qui permette de résister à des pics de tension, ou tension d'apparition des décharges partielles (PDIV) dont les valeurs sont imposées par l'avionneur. En général, un seuil d'amplitude (Vpeak) est établi pour ces tensions d'apparition des décharges partielles, qui tient compte des phénomènes transitoires, ondulatoires et de réflexion, mais également de marge de sécurité.

Le but de la présente invention est de remédier à au moins un des inconvénients de l'art antérieur en termes de poids, d'encombrement et de facilité d'usage en proposant un câble électrique possédant un système d'isolation lui permettant d'être soumis à des tensions et intensités élevées tout en limitant voire évitant l'apparition de décharges partielles, tels que le système d'isolation est d'épaisseur moindre.

La présente invention a pour premier objet un câble aéronautique limitant l'apparition de décharges partielles, comprenant un élément électriquement conducteur allongé et une couche semi-conductrice entourant l'élément électriquement conducteur allongé et un système d'isolation comportant une ou plusieurs couches électriquement isolantes entourant ladite couche semiconductrice, tel que chaque couche du système d'isolation présente une épaisseur radiale, et en ce qu'une épaisseur équivalente d'isolation de ce système d'isolation est supérieure ou égale au résultat d'une équation polynomiale fonction d'une pression minimale et d'une température maximale auxquelles le câble est destiné à être utilisé. De préférence, cette équation polynomiale peut être d'ordre 3 et fonction d'une tension d'apparition de décharges partielles (PDIV) sur le câble dans lesdites conditions de pression minimale et de température maximale.

Avantageusement, l'épaisseur de la couche d'isolation est réduite par rapport aux câbles de l'art antérieur cherchant à éviter les l'apparition de décharges partielles, ce qui permet à l'élément électriquement conducteur d'être léger et de pouvoir être utilisé dans des domaines nécessitant des câbles électriques légers comme par exemple l'aéronautique.

Selon un mode de réalisation préféré, la détermination de l'épaisseur de la ou des couches d'isolations peut faire intervenir un calcul, par exemple un calcul mis en œuvre par ordinateur. En particulier, les demandeurs ont découvert que la loi de Paschen permettaient de modéliser le comportement de l'isolation d'un câble dont la structure est un ensemble d'épaisseurs concentriques, en recherchant le seuil de la tension de claquage dans l'air entre deux électrodes, dont l'une est recouverte d'une isolation correspondante en épaisseur à celle du câble, et telles qu'une tension donnée, tension pouvant correspondre au seuil de tension d'apparition des décharges partielles dans le câble, est appliquée aux électrodes.

Ainsi, la tension d'apparition de décharges partielles (PDIV) dans les conditions de pression minimale et de température maximale prise en compte dans l'invention peut être définie à une valeur supérieure à une tension de claquage dans l'air entre deux électrodes dont l'une est recouverte par un système d'isolation dont les matériaux et l'épaisseur sont respectivement identiques à ceux du système d'isolation du câble.

Plus particulièrement, l'épaisseur équivalente d'isolation $t_{eq}$ peut être telle que:

[Math. 1]

$$t_{eq} \geq \sum_{n=1}^{4} a_n \cdot PDIV^{n-1}$$

avec

[Math. 2]

$$a_n = \sum_{m=1}^{4} b_{n,m} \cdot {p_T}^{n-1}$$

et

[Math. 3]

$$p_T = \frac{273,15}{273,15 + T}$$

Où $p_T$ est la pression minimale ,notamment une pression minimale comprise entre 90 et 1100 hPa

$T$ est la température maximale, notamment une température comprise entre - 65 et 260 °C
et PDIV représente la tension d'apparition de décharges partielles dans les conditions de pression minimale et de température maximale, notamment d'une amplitude comprise entre 0,8 et 5 kV (kV$_{peak}$).

L'invention a également pour objet un système d'isolation multicouche tel que l'épaisseur équivalente d'isolation $t_{eq}$ est déterminée en fonction des épaisseurs radiales respectives de chacune des couches formant le système d'isolation et telle que:

[Math.4]

$$t_{eq} = \sum_{x=1}^{Nombre\ de\ couches\ de\ l'isolation} \frac{e_x}{\varepsilon_{rx}}$$

où $e_x$ est l'épaisseur d'une couche x
et $\varepsilon_{rx}$ est la permittivité de la couche x.

En particulier ces câbles sont destinés à être utilisés dans des conditions de température maximale qui peuvent être inférieures ou égales à 260°C, et ou de pression minimale d'au moins 90 hPa et au maximum de 1100 hPa.

De préférence, un usage du câble selon l'invention vise un usage dans lequel le système d'isolation peut définir en tout ou partie le pourtour extérieur du câble exposé à une atmosphère extérieure pouvant correspondre à la pression minimale et ou à la température maximale. En particulier, le câble peut néanmoins être recouvert d'une tresse, laissant le système d'isolation pour partie accessible à l'atmosphère extérieure. Cette tresse peut avoir une fonction de blindage électromagnétique ou une fonction d'un conducteur électrique.

Alternativement, l'invention peut également avoir pour objet un système d'isolation entouré d'une tresse, elle-même recouverte d'une gaine.

Plus particulièrement, un câble selon l'invention peut être dépourvu de couche semi-conductrice radialement extérieure au système d'isolation. Dit autrement, le câble peut comporter une unique couche semi-conductrice, celle qui est disposée entre le conducteur et le système d'isolation.

Enfin pour améliorer le contrôle visuel et la surveillance de l'état et de la sécurité du câble, le système d'isolation peut comporter une couche comportant des pigments colorés. Ainsi, lorsqu'un tel câble ne présente pas de couleur uniforme, cela permet de localiser les zones abîmées.

L'invention a également pour objet une utilisation d'un câble selon l'invention dans un avion dont les altitudes maximales de vol sont telles que la pression minimale à laquelle est utilisé le câble est fonction de cette altitude maximale de vol.

Couche électriquement isolante

De préférence, la couche semi-conductrice présente une épaisseur $e_1$, la valeur de l'épaisseur $e_i$ de la couche électriquement isolante satisfait à la relation suivante :

[Math. 5]

$$ei \geq e1$$

Dans la présente invention, la somme des épaisseurs ei du système d'isolation est notamment une épaisseur radiale moyenne qui peut varier de ± 30%, de préférence de ± 20%, et de façon particulièrement préférée de ± 10% par rapport à cette épaisseur radiale moyenne. Cette variation d'épaisseur peut être aléatoire et être due en particulier au procédé d'application de ladite couche sur l'élément ou la couche qu'elle entoure.

La couche électriquement isolante peut comprendre au moins une silicone, et ou une silicone fluorée, et ou un polymère d'oléfine choisi parmi un polyéthylène linéaire basse densité (LLDPE); un polyéthylène très basse densité (VLDPE); un polyéthylène basse densité (LDPE); un polyéthylène moyenne densité (MDPE); un polyéthylène haute densité (HDPE); un copolymère élastomère d'éthylène-propylène (EPM); un terpolymère éthylène propylène diène monomère (EPDM); un copolymère d'éthylène et de vinyl ester tel qu'un copolymère d'éthylène et d'acétate de vinyl (EVA); un copolymère d'éthylène et d'acrylate tel qu'un copolymère d'éthylène et d'acrylate de butyle (EBA) ou un copolymère d'éthylène et d'acrylate de méthyle (EMA); un copolymère d'éthylène et d'alpha-oléfine tel qu'un copolymère d'éthylène et d'octène (PEO) ou un copolymère d'éthylène et de butène (PEB); un polymère fluoré, notamment choisi parmi les copolymères obtenus à partir du monomère de tétrafluoroéthylène, et en particulier parmi le polytétrafluoroéthylène (PTFE), les copolymères d'éthylène et de propylène fluorés (FEP) comme par exemple les poly(tétrafluoroéthylène-co-hexafluoropropylène), les copolymères perfluoroalkoxy (PFA) comme par exemple les copolymères perfluoro(alkylvinyléther)/tétrafluoroéthylène, les copolymères perfluoro méthoxy (MFA), et les poly(éthylène-co-tétrafluoroéthylène) (ETFE) ; et un de leurs mélanges.

De préférence, la couche électriquement isolante peut comprendre au moins un polymère fluoré, notamment choisi les copolymères obtenus à partir du monomère de tétrafluoroéthylène, et en particulier parmi le polytétrafluoroéthylène (PTFE) ; les copolymères d'éthylène et de propylène fluorés (FEP) comme par exemple les poly(tétrafluoroéthylène-co-hexafluoropropylène) ; les copolymères perfluoroalkoxy (PFA) comme par exemple les copolymères perfluoro(alkylvinyléther)/tétrafluoroéthylène ; les copolymères perfluoro méthoxy (MFA) ; et les poly(éthylène-co-tétrafluoroéthylène) (ETFE) ; ou un de leurs mélanges.

De façon particulièrement préférée, la couche électriquement isolante peut comprendre un ou plusieurs copolymères perfluoroalkoxy (PFA).

De préférence, la couche électriquement isolante peut comprendre la même composition polymérique que la couche semi-conductrice.

Dans la présente invention, une composition polymérique correspond à une composition comprenant un ou plusieurs polymères en quantité déterminée, et notamment avec des pourcentages en poids de polymères déterminés. La composition polymérique comporte essentiellement un ou plusieurs polymères, de préférence uniquement un ou plusieurs polymères.

De préférence, la couche électriquement isolante peut comprendre la même composition polymérique que la couche semi-conductrice, la composition polymérique comprenant un ou plusieurs copolymères perfluoroalkoxy (PFA).

La couche électriquement isolante peut comprendre au moins 50% en poids de polymère(s), de préférence au moins 70% en poids de polymère (s), de manière encore plus préférée au moins 80% en poids de polymère(s), et de manière encore plus préférée au moins 90% en poids de polymère (s).

La couche électriquement isolante de l'invention peut comprendre classiquement des agents additionnels comme par exemple des charges, des pigments, des agents de réticulation, des charges ignifugeantes...

La couche électriquement isolante peut-être une couche extrudée autour de l'élément électriquement conducteur.

De préférence, la couche semi conductrice est extrudée autour de l'élément électriquement conducteur. De façon particulièrement préférée, la couche électriquement isolante est coextrudée avec la couche semi-conductrice, ensembles autour de l'élément électriquement conducteur.

Dans la présente invention, on entend par « couche électriquement isolante » une couche donc la conductivité électrique est très faible voire nulle, notamment inférieure à $10^{-6}$ S/m, et de préférence inférieure à $10^{-13}$ S/m, et ce dans la plage de température d'utilisation pouvant aller jusqu'à 260°C.

De préférence, la couche électriquement isolante de l'élément électriquement conducteur de l'invention peut présenter une permittivité diélectrique selon la norme ASTM D150 inférieure à 2,3, de préférence inférieure à 2,2, et de façon particulièrement préférée inférieure à 2,1 ; et ce, pour une fréquence comprise entre 100Hz et 100kHz et à une température de 0 à 200°C .

Selon un mode de réalisation préféré, l'élément électriquement conducteur peut être utilisé dans le domaine de l'aéronautique.

Elément électriquement conducteur

L'élément électriquement conducteur allongé peut être un conducteur monocorps tel que par exemple un fil métallique ou un conducteur multicorps tel qu'une pluralité de fils métalliques torsadés ou non, de préférence une pluralité de fils métalliques, torsadés ou non, de manière à augmenter la flexibilité du câble. Lorsqu'il comporte une pluralité de fils métalliques, il peut s'agir de fils de Litz, tels que les fils de Litz sont émaillés, et particulièrement efficace pour des sections d'élément électriquement conducteur de section large afin d'améliorer la réduction les effets de peau, et de facto les pertes Joule et la surchauffe du câble. Lorsque le câble comprend une pluralité de fils métalliques, certains des fils métalliques au centre du conducteur peuvent être remplacés par des fils non métalliques.

L'élément électriquement conducteur allongé peut être en aluminium, en alliage d'aluminium, en cuivre, en alliage de cuivre, et un de leurs mélanges.

L'élément électriquement conducteur allongé peut comprendre un ou plusieurs nanotubes de carbone ou avec du graphène afin d'augmenter la conductivité électrique, la conductivité thermique et/ou la résistance mécanique.

Selon un mode de réalisation possible, l'élément électriquement conducteur peut être recouvert d'un métal ou d'un alliage différent du métal formant le conducteur ou différent de l'alliage formant le conducteur, tel que par exemple du nickel, un alliage de nickel, de l'étain, un alliage d'étain, de l'argent, un alliage d'argent, ou un de leurs mélanges. Un tel recouvrement, appelé placage, peut permettre de protéger le conducteur de la corrosion et/ou d'améliorer sa résistance de contact.

L'élément électriquement conducteur formé en un métal ou en un alliage de métal signifie que l'élément électriquement conducteur comprend au moins 70%, de préférence au 80%, et de façon encore plus préférée au moins 90% moins dudit métal ou dudit alliage.

L'élément électriquement conducteur peut avoir une section allant de 3 mm²(AWG 12) à 107mm²(AWG 0000), de préférence allant de 14 mm² (AWG 6) à 107 mm²(AWG 0000), de préférence allant de 34 mm²(AWG 2) à 107 mm²(AWG 0000), et de façon encore plus préférée allant de 68 mm² (AWG00) à 107 mm² (AWG0000).

L'élément électriquement conducteur peut avoir un diamètre extérieur allant de 2,0 mm à 20 mm, de préférence allant de 4,5mm à 18 mm, de préférence allant de 7,0 mm à 16 mm, et de façon encore plus préférée allant de 10 mm à 15,2 mm.

Couche semi-conductrice

La couche semi-conductrice peut comprendre au moins une silicone, et ou une silicone fluorée, et ou un polymère d'oléfine choisi parmi un polyéthylène linéaire basse densité (LLDPE); un polyéthylène très basse densité (VLDPE); un polyéthylène basse densité (LDPE); un polyéthylène moyenne densité (MDPE); un polyéthylène haute densité (HDPE); un copolymère élastomère d'éthylène-propylène (EPM); un terpolymère éthylène propylène diène monomère (EPDM); un copolymère d'éthylène et de vinyl ester tel qu'un copolymère d'éthylène et d'acétate de vinyl (EVA) ; un copolymère d'éthylène et d'acrylate tel qu'un copolymère d'éthylène et d'acrylate de butyle (EBA) ou un copolymère d'éthylène et d'acrylate de méthyle (EMA) ; un copolymère d'éthylène et d'alpha-oléfine tel qu'un copolymère d'éthylène et d'octène (PEO) ou un copolymère d'éthylène et de butène (PEB) ; un polymère fluoré, notamment choisi parmi les copolymères obtenus à partir du monomère de tétrafluoroéthylène, et en particulier parmi le polytétrafluoroéthylène (PTFE), les copolymères d'éthylène et de propylène fluorés (FEP) comme par exemple les poly(tétrafluoroéthylène-co-hexafluoropropylène), les copolymères perfluoroalkoxy (PFA) comme par exemple les copolymères perfluoro(alkylvinyléther)/tétrafluoroéthylène, les copolymères perfluoro méthoxy (MFA), et les poly(éthylène-co-tétrafluoroéthylène) (ETFE) ; et un de leurs mélanges.

De préférence, la couche semi-conductrice peut comprendre au moins un polymère fluoré, notamment choisi parmi le polytétrafluoroéthylène (PTFE) ; les copolymères d'éthylène et de propylène fluorés (FEP) comme par exemple les poly(tétrafluoroéthylène-co-hexafluoropropylène) ; les copolymères perfluoroalkoxy (PFA) comme par exemple les copolymères

perfluoro(alkylvinyléther)/tétrafluoroéthylène ; les copolymères perfluoro méthoxy (MFA) ; et les poly(éthylène-co-tétrafluoroéthylène) (ETFE) ; ou un de leurs mélanges.

De façon particulièrement préférée, la couche semi-conductrice peut comprendre un ou plusieurs copolymères perfluoroalkoxy (PFA).

La couche semi-conductrice peut comprendre au moins 50% en poids de polymère(s), de préférence au moins 70% en poids de polymère (s), de manière encore plus préférée au moins 80% en poids de polymère(s), et de manière encore plus préférée au moins 90% en poids de polymère (s).

La couche semi-conductrice de l'invention peut comprendre classiquement des charges électriquement conductrices. A titre d'exemple, elle peut comprendre de 0,1% à 40% en poids de charges électriquement conductrices, telles que par exemple du noir de carbone, des nanotubes de carbone ... La couche semiconductrice permet d'adoucir le champ électrique autour de l'élément électriquement conducteur.

La couche semi-conductrice peut-être une couche extrudée autour de l'élément électriquement conducteur allongé, ou une couche sous forme de ruban enroulé autour de l'élément électriquement conducteur allongé, ou une couche de vernis déposée autour de l'élément électriquement conducteur allongé, ou une de leurs combinaisons.

De préférence, la couche électriquement isolante est extrudée autour de la couche semi-conductrice.

La couche semi-conductrice peut posséder une épaisseur $e_1$ allant de 0,05 mm (millimètre) à 1,0 mm, de préférence allant de 0,07 mm à 0,8 mm, et de façon particulièrement préférée une épaisseur allant de 0,09 mm à 0,5 mm.

Dans la présente invention, on entend par « couche semi-conductrice » une couche dont la résistivité volumique est inférieure à 10 000 $\Omega$xm (Ohm mètre) (à température ambiante), de préférence inférieure à 1000 $\Omega$xm, et de façon particulièrement préférée inférieure à 500 $\Omega$xm.

Selon un mode de réalisation préféré, la couche semi-conductrice peut être directement placée autour de l'élément électriquement conducteur et donc être en contact physique direct avec ledit élément. La couche semi-conductrice permet ainsi de lisser le champ électrique autour du conducteur.

La couche semi-conductrice peut posséder un diamètre extérieur allant de 0,3 mm à 22 mm, de préférence allant de 0,8 mm à 18 mm, de préférence allant de 1,0 mm à 16 mm, et de façon particulièrement préférée allant de 1,2 mm à 12 mm.

Câble formant un unique élément électriquement conducteur isolé

Le câble selon l'invention peut être utilisé à une intensité pouvant aller de 35 A$_{RMS}$ à 1000 A$_{RMS}$, de préférence de 80 A$_{RMS}$ à 600 A$_{RMS}$, , de façon particulièrement préférée de 190 A$_{RMS}$ à 500 A$_{RMS}$, ces valeurs étant indiquées pour une température maximale du conducteur en service de 260°C.

Le câble selon l'invention peut être utilisé en courant continu ou en courant alternatif. Lorsqu'il est utilisé en courant alternatif, la fréquence d'utilisation peut aller de 10 Hz (Hertz) à 100 kHz (kilohertz), de préférence de 10 Hz à 10 kHz, de façon particulièrement préférée de 10 Hz à 3 kHz. Dans un système MLI on entend par fréquence la fréquence fondamentale du courant.

Le câble selon l'invention peut être utilisé, dans un aéronef en zone pressurée et non-pressurée, à une puissance allant de 8 kVA (kilovoltampère) à 3000 kVA, de préférence de 100 kVA à 2000 kVA, et de façon particulièrement préférée de 250 kVA à 1500 kVA.

Câble électriquement conducteur

Un deuxième objet de l'invention concerne un câble électriquement conducteur comprenant un ou plusieurs éléments électriquement conducteurs isolés tels que précédemment décrits.

Les valeurs de tension, d'intensité, de puissance et de fréquence décrites pour le câble formant un unique élément électriquement conducteur isolé s'appliquent également pour le câble électriquement conducteur.

Le câble électrique peut comprendre un écran métallique formant un blindage électromagnétique. Dans le cas où le câble comprend un unique élément électriquement conducteur isolé, l'écran métallique peut être placé autour de l'élément électriquement isolant. Dans le cas où le câble comprend plusieurs éléments électriquement conducteurs isolés, l'écran métallique peut également être placé autour de l'ensemble des éléments électriquement conducteurs isolés.

En outre, le câble électriquement conducteur peut comprendre une gaine de protection.

La gaine de protection peut être une couche à base de polymères tels que ceux décrit pour la couche électriquement isolante. Pour une application dans le domaine de l'aéronautique, la gaine de protection peut être de préférence à base d'un ou plusieurs polymères fluorés (comme par exemple du type PTFE, FEP, PFA et/ou ETFE) et/ou de polyimide.

De préférence, la gaine de protection peut être la couche la plus extérieure du câble.

La gaine de protection peut être sous forme d'un ruban, d'un extrudât ou d'un vernis.

**Brève description des dessins**

Les dessins annexés illustrent l'invention :

[Fig. 1] représente une vue en coupe transversale d'un câble selon l'invention ;

[Fig. 2] représente un graphique des évolutions d'une épaisseur équivalente (teq) d'isolation d'un câble selon l'invention en fonction de différentes pression minimale et pour une température maximale de 150 °C auxquelles le câble est destiné à être utilisé.

**Description de mode(s) de réalisation**

Pour des raisons de clarté, seuls les éléments essentiels pour la compréhension des modes de réalisation exposés ci-après ont été représentés de manière schématique, et ceci sans respect de l'échelle.

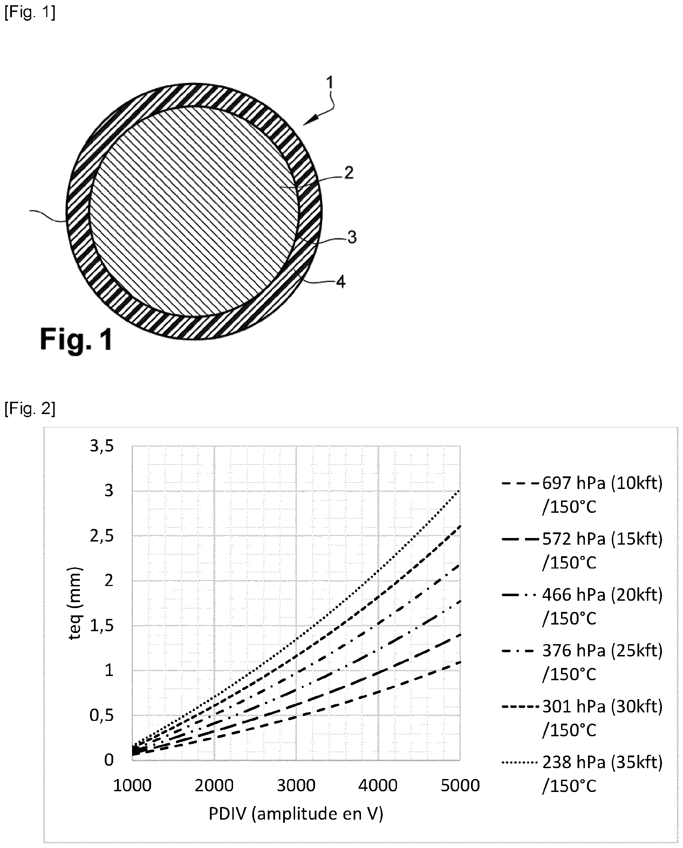

Comme illustré sur la figure 1, un câble formant un unique élément électriquement conducteur isolé 1 selon un mode de réalisation de l'invention comprend un élément électriquement conducteur allongé 2, une couche semi-conductrice 3 entourant l'élément électriquement conducteur allongé 2, et une couche électriquement isolante 4 entourant la couche semi-conductrice 3.

L'élément électriquement conducteur allongé 2 est formé par 37 brins en cuivre recouvert par une couche de nickel et possède ainsi à un diamètre de 12 AWG (« American Wire Gauge »).

Le matériau de la couche semi-conductrice 3 et de la couche isolante 4 comporte du PFA. La couche semi-conductrice est formée à partir d'un mélange polymérique A comprenant au moins 60 % en poids de copolymère perfluoroalkoxy (PFA) par rapport au poids total du mélange polymérique. Le mélange polymérique A est par exemple commercialisé sous la référence S185.1 B par la société PolyOne.

La couche électriquement isolante est formée à partir d'un deuxième mélange polymérique B comprenant au moins 95 % en poids de copolymère perfluoroalkoxy (PFA) par rapport au poids total du mélange polymérique. Le mélange polymérique B est par exemple commercialisé sous la référence AP-210 par la société DAIKIN. La permittivité de ce matériau est de matériau obtenu par polymérisation du mélange polymérique B est de 2,1.

Les mélanges polymériques A et B ont été chacun introduits dans une des deux extrudeuses de la coextrusion bi-couche et extrudés autour de l'élément électriquement conducteur allongé 2.

Le câble selon l'invention pour résister à une « pression à température de vol » PT est déterminé de sorte que [Math. 2]

$$p_T = \frac{273,15}{273,15 + T}$$

Où $p_T$ est la pression minimale
$T$ est la température maximale. Et tel que avec les coefficients $b_{n,m}$ sont les suivants

| $b_{n,m}$ | n=1 | n=2 | n=3 | n=4 |
|---|---|---|---|---|
| m=1 | -0,58133 | 0,81629 | 0,02282 | 0,00864 |
| m=2 | 2,11632 | -2,91153 | -0,02497 | -0,03217 |
| m=3 | -2,88833 | 3,94018 | 0,01584 | 0,04238 |

(suite)

| $b_{n,m}$ | n=1 | n=2 | n=3 | n=4 |
|---|---|---|---|---|
| m=4 | 1,31095 | -1,78528 | -0,01122 | -0,01814 |

et permettent de calculer les coefficients de l'équation polynomiale d'ordre 3 pour une pression minimale donnée et une température maximale donnée, où

[Math. 2]

$$a_n = \sum_{m=1}^{4} b_{n,m} \cdot p_T^{\,n-1}$$

Et lorsqu'un utilisateur fixe un seuil de résistance PDIV exprimé en amplitude (kVpeak en anglais) représentant l'amplitude de la tension d'apparition de décharges partielles (PDIV) dans ces conditions de pression minimale et de température maximale à une valeur donnée, il est alors possible, grâce à l'invention, de déterminer l'épaisseur équivalente d'isolation $t_{eq}$ nécessaire pour ce câble en appliquant l'équation ci-dessous.

[Math. 1]

$$t_{eq} \geq \sum_{n=1}^{4} a_n \cdot PDIV^{\,n-1}$$

Il est ainsi déterminé pour une pression minimale de 1000 mbar et une température maximale donnée de 80°C, et un seuil de résistance PDIV de 3,946 kV d'amplitude (Vpeak), l'épaisseur équivalente (teq) d'isolation de ce système d'isolation doit être de 0,4762 mm.

| a1 | -0,06576 |
|---|---|
| a2 | 0,09544 |
| a3 | 0,00779 |
| a4 | 0,00072 |

Cette épaisseur équivalente teq d'isolation de ce système d'isolation est ensuite traduite en épaisseur radiale, en fonction de la permittivité du ou des matériaux formant le système d'isolation.

Un exemple de réalisation d'un câble répondant aux contraintes de pression minimale de 1000 mbar et une température maximale donnée de 80°C, et un seuil de résistance PDIV de 3,946 kV a alors les dimensions ci-dessous

- diamètre moyen du conducteur = 2,15 mm ($\pm$ 10%) ;
- épaisseur moyenne de l'unique couche d'isolation du système d'isolation, lorsque la permittivité est de 2,10, est de l'ordre de 1 mm,

L'invention a également pour objet un système d'isolation multicouche tel que l'épaisseur équivalente d'isolation $t_{eq}$ est déterminée en fonction des épaisseurs radiales respectives de chacune des couches formant le système d'isolation et telle que:

[Math.4]

$$t_{eq} = \sum_{x=1}^{Nombre\ de\ couches\ de\ l'isolation} \frac{e_x}{\varepsilon_{rx}}$$

où $e_x$ est l'épaisseur radiale d'une couche x

et $\varepsilon_{rx}$ est la permittivité de la couche x.

Pour une épaisseur de la couche électriquement isolante ei de 0,50 mm et une permittivité de 2,10, on obtient une bonne concordance entre les résultats mesurés et les résultats calculés comme le montrent les résultats ci-dessous. Les tensions d'apparition de décharges partielles (TADP ou PDIV) mesurées sont exprimées par la moyenne de 10 mesures et le coefficient de variation (le ratio entre l'écart type et la moyenne). La PDIV mesurée est proche de la PDIV calculée et est légèrement supérieure. Ainsi l'invention assure une opération sans décharges partielles dans la limite de la PDIV spécifiée sans une marge excessive sur la détermination de la PDIV, qui conduirait à une épaisseur et donc masse trop importante.

| Température maximale [°C]. | Pression minimale [mbar] | Moyenne des mesures [Vpeak] | Coefficient de variation | PDIV calculé [Vpeak] | Différence entre PDIV calculé et moyenne des mesures [%] |
|---|---|---|---|---|---|
| 40 | 200 | 1216 | 4% | 1213 | 0,3% |
| 40 | 400 | 1761 | 4% | 1655 | 6,4% |
| 40 | 600 | 2227 | 3% | 2218 | 0,4% |
| 40 | 800 | 2616 | 4% | 2536 | 3,2% |
| 40 | 1000 | 2871 | 5% | 2802 | 2,5% |

Pour une épaisseur de la couche électriquement isolante ei de 1 mm et une permittivité de 2,10, on obtient les résultats ci-dessous. Là encore, on démontre une bonne concordance entre les résultats mesurés et les résultats calculés pour différentes pression minimale et différentes températures maximales.

| Température maximale [°C] | Pression minimale [mbar] | Moyenne des mesures [Vpeak] | Coefficient de variation | PDIV calculé [Vpeak] | Différence entre PDIV calculé et moyenne des mesures [%] |
|---|---|---|---|---|---|
| 40 | 200 | 1716 | 6% | 1655 | 3,7% |
| 40 | 400 | 2665 | 2% | 2433 | 9,5% |
| 40 | 600 | 3336 | 3% | 3326 | 0,3% |
| 40 | 800 | 4048 | 3% | 3820 | 6,0% |
| 40 | 1000 | 4642 | 3% | 4225 | 9,9% |
| 80 | 200 | 1710 | 4% | 1601 | 6,8% |
| 80 | 400 | 2494 | 3% | 2231 | 11,8% |
| 80 | 600 | 3174 | 5% | 3046 | 4,2% |
| 80 | 800 | 3725 | 4% | 3655 | 1,9% |
| 80 | 1000 | 4149 | 3% | 3946 | 5,2% |

Dans un autre exemple, pour un seuil PDIV de 1000Vrms soit 1414 Vpeak en amplitude, pour une altitude de vol maximum de 35kft, correspondant à une exposition à une pression minimale de 238mbar et une température maximales de 150°C , une teq = 0,367mm correspond à une couche électriquement isolante formée à 95 % en poids de copolymère perfluoroalkoxy (PFA) d'épaisseur radiale de 0.79mm.

**Revendications**

1.  Câble aéronautique limitant l'apparition de décharges partielles, **caractérisé en ce qu'**il comprend un élément électriquement conducteur allongé, une couche semi-conductrice entourant l'élément électriquement conducteur allongé et un système d'isolation comportant au moins une couche électriquement isolante entourant ladite couche semi-conductrice, **caractérisé en ce que** chaque couche du système d'isolation présente une épaisseur radiale (ei... ), et **en ce qu'**une épaisseur équivalente (teq) d'isolation de ce système d'isolation est supérieure au résultat d'une équation polynomiale fonction d'une pression minimale et d'une température maximale auxquelles le câble est destiné à être utilisé.

**2.** Câble selon la revendication 1, **caractérisé en ce que** l'équation polynomiale est d'ordre 3 et fonction d'une tension d'apparition de décharges partielles (PDIV) sur le câble dans les conditions de pression minimale et de température maximale.

**3.** Câble selon la revendication 2, **caractérisé en ce que** la tension d'apparition de décharges partielles (PDIV) dans les conditions de pression minimale et de température maximale est supérieure ou égale à une tension de claquage dans l'air entre deux électrodes planes dont l'une est recouverte par un système d'isolation dont les matériaux et l'épaisseur sont respectivement identiques à ceux du système d'isolation du câble.

**4.** Câble selon l'une quelconque des revendications précédentes, **caractérisé en ce que** l'épaisseur équivalente d'isolation $t_{eq}$ , en mm, est telle que:

[Math. 1]

$$t_{eq} \geq \sum_{n=1}^{4} a_n \cdot PDIV^{n-1}$$

avec

[Math. 2]

$$a_n = \sum_{m=1}^{4} b_{n,m} \cdot p_T^{\,n-1}$$

et

[Math. 3]

$$p_T = \frac{273,15}{273,15 + T}$$

Où $p_T$ est la pression minimale en mbar ou hPa
$T$ est la température maximale en degrés Celsius
et PDIV représente une amplitude de la tension d'apparition de décharges partielles, en kV (kVpeak), dans les conditions de pression minimale et de température maximale.

**5.** Câble selon la revendication 4 **caractérisé en ce que** les coefficients sont les suivants :

| $b_{n,m}$ | n=1 | n=2 | n=3 | n=4 |
|---|---|---|---|---|
| m=1 | -0,58133 | 0,81629 | 0,02282 | 0,00864 |
| m=2 | 2,11632 | -2,91153 | -0,02497 | -0,03217 |
| m=3 | -2,88833 | 3,94018 | 0,01584 | 0,04238 |
| m=4 | 1,31095 | -1,78528 | -0,01122 | -0,01814 |

6. Câble selon l'une quelconque des revendications précédentes, **caractérisé en ce que** l'épaisseur équivalente d'isolation $t_{eq}$ est déterminée en fonction des épaisseurs radiales respectives des couches formant l'isolation et telle que:

[Math.4]

$$t_{eq} = \sum_{x=1}^{\text{Nombre de couches de l'isolation}} \frac{e_x}{\varepsilon_{rx}}$$

où $e_x$ est l'épaisseur d'une couche x
et $\varepsilon_{rx}$ est la permittivité de la couche x.

7. Câble selon l'une quelconques des revendications précédentes, **caractérisé en ce que** la température maximale est au maximum de 260°C, de préférence supérieure à - 65°C.

8. Câble selon l'une quelconques des revendications précédentes, **caractérisé en ce que** la pression minimale est d'au moins 90 hPa et au maximum de 1100 hPa.

9. Câble selon l'une quelconques des revendications précédentes, **caractérisé en ce que** le système d'isolation définit en tout ou partie le pourtour extérieur du câble exposé à une atmosphère extérieure pouvant correspondre à la pression minimale et ou à la température maximale.

10. Câble selon la revendication précédente, **caractérisé en ce que** le système d'isolation est recouvert d'une tresse.

11. Câble selon l'une quelconques des revendications 1 à 8, **caractérisé en ce que** le système d'isolation est entouré d'une tresse, elle-même recouverte d'une gaine.

12. Câble selon l'une quelconques des revendications précédentes, **caractérisé en ce qu'**il comporte une unique couche semi-conductrice.

13. Câble selon l'une quelconques des revendications précédentes, **caractérisé en ce que** le système d'isolation comporte une couche comportant des pigments colorés.

14. Utilisation d'un câble selon l'une quelconque des revendications 1 à 13 dans un avion dont les altitudes maximales de vol sont telles que la pression minimale à laquelle est utilisé le câble est fonction de cette altitude maximale de vol.

[Fig. 1]

Fig. 1

[Fig. 2]

Europäisches
Patentamt

European
Patent Office

Office européen
des brevets

**RAPPORT DE RECHERCHE EUROPEENNE**

Numéro de la demande

**EP 22 17 3617**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2012/159221 A1 (BACAB S A [CH]; COLPA MARIO [CH] ET AL.) 29 novembre 2012 (2012-11-29) | 1,7,12 | INV. H01B7/30 H01B7/28 |
| Y | * page 1, ligne 4 – ligne 6 * * page 1, ligne 7 – ligne 9 * * page 6, ligne 12 – ligne 13 * * page 6, ligne 19 – ligne 22 * * page 6, ligne 15 – ligne 16 * * page 7, ligne 6 – ligne 8 * * figure 1 * * revendication 1 * ----- | 10,11,13 | H01B7/29 |
| Y | EP 3 358 575 A1 (NEXANS [FR]; SAFRAN ELECTRICAL & POWER [FR]) 8 août 2018 (2018-08-08) | 13 | |
| A | * alinéa [0056] * ----- | 1 | |
| Y | Nexans: "Complete, reliable cables range for Aircraft Issue 8 –June 2011", , 8 juin 2011 (2011-06-08), pages 1-252, XP055091480, Extrait de l'Internet: URL:http://www.nexans.fr/France/2011/BD_NE XANS_catal_aircraft_EN.pdf [extrait le 2013-12-04] * page 34 * ----- | 10,11 | |

|  |  |
|---|---|
|  | DOMAINES TECHNIQUES RECHERCHES (IPC) |
|  | H01B H05B |

Le présent rapport a été établi pour toutes les revendications

| Lieu de la recherche | Date d'achèvement de la recherche | Examinateur |
|---|---|---|
| La Haye | 14 septembre 2022 | Bossi, Paolo |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 22 17 3617

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-09-2022

| Document brevet cité au rapport de recherche | Date de publication | Membre(s) de la famille de brevet(s) | Date de publication |
|---|---|---|---|
| WO 2012159221 A1 | 29-11-2012 | CH 704993 A1<br>WO 2012159221 A1 | 30-11-2012<br>29-11-2012 |
| EP 3358575 A1 | 08-08-2018 | EP 3358575 A1<br>FR 3062748 A1 | 08-08-2018<br>10-08-2018 |

Pour tout renseignement concernant cette annexe : voir Journal Officiel de l'Office européen des brevets, No.12/82